# EUROPÄISCHE PATENTANMELDUNG

(11) **EP 3 285 554 A1**
(43) Veröffentlichungstag der Anmeldung: **21.02.2018**
(21) Anmeldenummer: 17186165.1
(22) Anmeldetag: 14.08.2017
(51) Int. Cl.: H05K 1/14, H01R 12/62

(54) **ELEKTRONISCHE REGELUNG MIT BEDIENKNÖPFEN**

(30) Priorität: 17.08.2016 DE 102016215330
(71) Anmelder: Vaillant GmbH, 42859 Remscheid (DE)
(72) Erfinder: Lebret, Sébastien, 443300 Nantes (FR); Rouland, Jérôme, 49270 Landemont (FR)
(74) Vertreter: Hocker, Thomas

(57) **Zusammenfassung**

Bei einem Display einer Heizungsanlage zum Anzeigen von Betriebszuständen, Fehlermeldungen und anderen Informationen ist das Display als elektronisches Papier ausgeführt.

## Beschreibung

Die Erfindung bezieht sich auf eine elektronische Regelung mit Bedienknöpfen.

Bei Heizungsanlagen werden zumeist Regelungsgeräte eingesetzt, bei denen Parameter wie Vorlauftemperatur, Absenkzeiten sowie Winter- und Sommerbetrieb eingestellt werden können. Heizungshersteller sind aus Kostengründen bemüht, möglichst viele Gleichteile zu verwenden. Da jedoch unterschiedliche Heizungsanlagen unterschiedlichen Rahmenbedingungen unterliegen, haben diese unterschiedliche Bedienkonzepte. Hieraus wiederum resultieren unterschiedliche Gestaltungen der Anzeigen und Bedienelemente. Um die Anzahl von Variantenkonstruktionen zu reduzieren, verfügen häufig Platinen über eine Vielzahl von Schaltern und Tastern, auf die eine Blende aufgesetzt wird, wobei diese Blende dann einen Teil der Schalter und Taster abdeckt, so dass nur ein Teil der Vielzahl von Schaltern und Tastern betätigt werden können. Nachteilig hierbei ist, dass bei einer irgendwann festgelegten Positionierung der Schalter und Taster auf der Platine spätere Bedienblenden daran gebunden sind.

Aufgabe der Erfindung ist eine flexible Gestaltung des Bedienfeldes zu erlauben.

Diese Aufgabe wird erfindungsgemäß dadurch gelöst, dass das Bedienfeld vom Design der Platine gelöst wird und sich auf einer flexiblen Leiterplatte befindet, die mit der Platine verbunden wird.

Vorteilhafte Ausgestaltungen ergeben sich durch die Merkmale der abhängigen Ansprüche.

Die Erfindung wird anhand der Figuren erläutert.

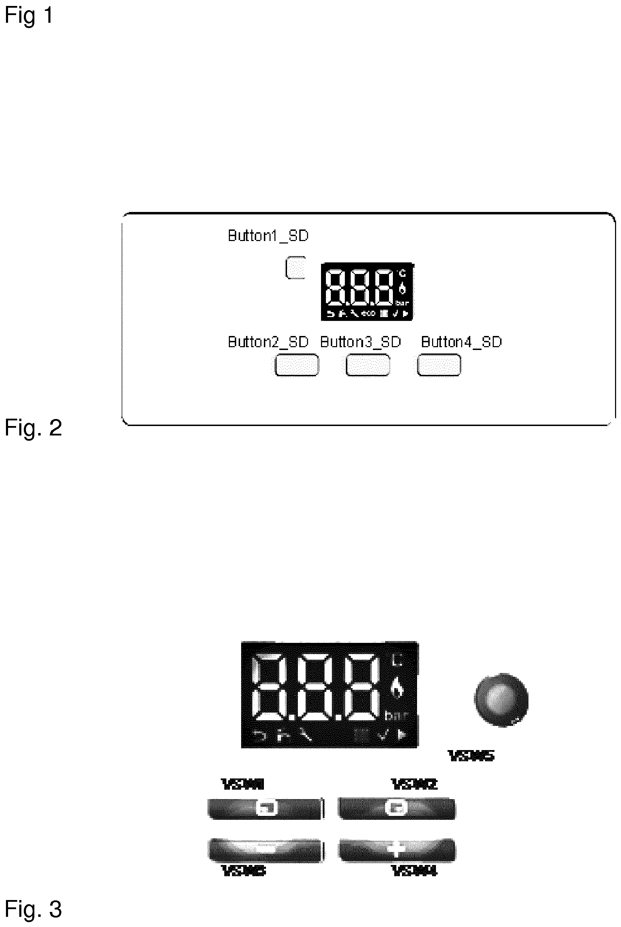

Figur 1 zeigt eine Platine 1 (Printed Circuit Board PCB) mit einem Display 2 gemäß dem Stand der Technik mit einer Vielzahl von Tastern 3 auf der Platine 1. Figur 2 zeigt dieselbe Platine 1, bei der eine erste Blende 4 derart aufgesetzt ist, dass lediglich drei der Taster 3 nebeneinander betätigt werden können. Figur 3 zeigt dieselbe Platine 1, bei der eine andere Blende 4 derart aufgesetzt ist, dass vier andere Taster 3, welche ein Rechteck bilden, betätigt werden können.

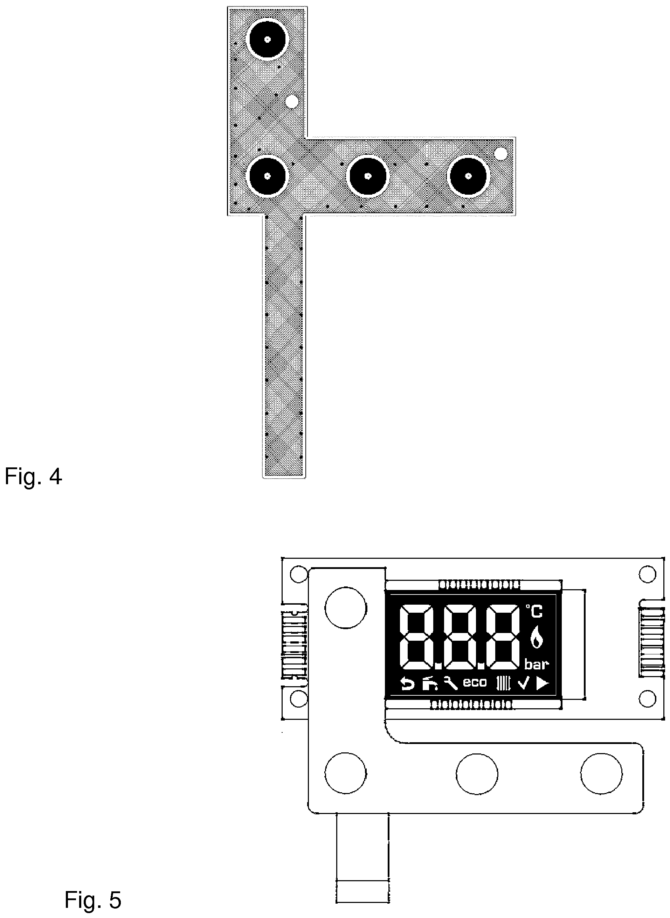

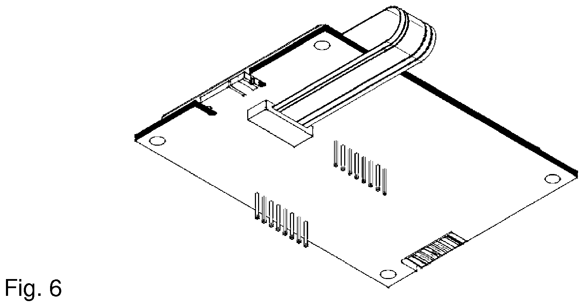

Figur 4 zeigt eine flexible Leiterplatte 5 mit einem Stecker 6 und vier kapazitiven Tastern 7. Die flexible Leiterplatte 5 kann auf Basis von Polyester- oder Polyimid-Folien mit einer Dicke von etwa 125 µm hergestellt werden. Die Leiterbahnen werden mittels Silbertinte oder Kupfer aufgebracht. Die kapazitiven Sensoren 7 wird durch Berührung mittels eines Fingers betätigt und führt durch die Leitfähigkeit der Haut zu einem Stromfluss; er bedingt hierzu auf der flexible Leiterplatte 5 lediglich eine Kontaktfläche. Figur 5 zeigt die die flexible Leiterplatte 5 in Verbindung mit einer Platine 1 mit Display 2. Figur 6 zeigt, dass die flexible Leiterplatte 5 mittels des Steckers mit der Platine 1 verbunden ist.

Bei einem Heizungsgerät kann die Platine 1 an einer belieben Stelle eingebaut werden. Befindet sich ein Display 2 direkt auf der Platine 1, so muss der Einbau derart erfolgen, dass das Display durch eine Öffnung im Gehäuse gesehen werden kann. Die flexible Leiterplatte 7 kann unabhängig von der Platine 1 derart angeordnet werden, dass die kapazitiven Taster 7 außen am Gehäuse bedient werden können. Der Teil der flexiblen Leiterplatte 5, auf der sich die Taster 7 befinden, kann hierbei auf einem Teil des Heizungsgehäuses aufgebracht sein, wobei die flexible Verbindung durch einen Spalt im Gehäuse geschieht.

Bei den Tastern können auch andere Sensoren verwendet werden, bei denen beispielsweise ein Kontakt geschlossen oder eine Kapazität verändert wird.

Das Display 2 kann fest mit der Platine 1 verbunden sein. Es ist auch möglich, dass das Display 2 mittels einer Steckverbindung unmittelbar auf die Platine gesteckt wird oder mittels eines angesteckten Kabels verbunden ist.

Bei einem Heizungsgerät kann die flexible Leiterplatte 5 im Bereich der Bedienungselemente 5 mit einem Gehäuseteil auf der Außenseite des Heizungsgerätes verbunden werden, so dass das Heizungsgerät auf der Außenseite des Heizungsgeräts bedient wird, während die Platine 1 innerhalb des Heizungsgeräts angeordnet ist.

### Bezugszeichenliste

1 Platine
2 Display
3 Taster
4 Blende
5 flexible Leiterplatte
6 Stecker
7 Sensor

## Patentansprüche

1. Regeleinrichtung, vorzugsweise für eine Heizungsanlage, mit einer Platine (1) und Bedienungselementen (3, 5),
**dadurch gekennzeichnet, dass** die Bedienungselemente (3, 5) auf einer flexiblen Leiterplatte (5), welche mittels einer Steckverbindung (6) mit der Platine (1) verbunden ist, aufgebracht sind.

2. Regeleinrichtung nach Anspruch 1, **dadurch gekennzeichnet, dass** ein Display (2) auf der Platine (1) vorhanden ist oder mit der Platine über eine Steckverbindung mit oder ohne Kabel verbunden ist.

3. Regeleinrichtung nach Anspruch 1 oder 2, **dadurch gekennzeichnet, dass** die Bedienungselemente (3, 5) kapazitive Taster sind.

4. Regeleinrichtung nach einem der Ansprüche 1 bis 3, **dadurch gekennzeichnet, dass** die flexible Leiterplatte (5) aus Polyester- oder Polyimid-Folien mit aufgebrachten Leiterbahnen bestehen.

5. Regeleinrichtung nach einem der Ansprüche 1 bis 4, **dadurch gekennzeichnet, dass** die Regeleinrichtung eine Steuereinrichtung umfasst und dass die Steuereinrichtung so ausgestaltet ist, dass sie die angeschlossene Belegung der Platine (1) mit Bedienungselementen (3, 5) und/oder Display (2) erkennt und die Regeleinrichtung an die angeschlossene Platine (1) anpasst.

6. Regeleinrichtung nach einem der Ansprüche 1 bis 4, **dadurch gekennzeichnet, dass** die Regeleinrichtung so ausgestaltet ist, dass sie gleichzeitig mit unterschiedlichen Belegungen der Platine (1) mit Bedienungselementen (3, 5) und/oder Display (2) zusammenwirken kann.

7. Heizungsgerät mit einer Regeleinrichtung nach einem der Ansprüche 1 bis 6, **dadurch gekennzeichnet, dass** die flexible Leiterplatte (5) im Bereich der Bedienungselemente (5) mit einem Gehäuseteil auf der Außenseite des Heizungsgerätes verbunden ist.
